# EUROPEAN PATENT SPECIFICATION

(11) **EP 3 793 216 B1**
(45) Date of publication and mention of the grant of the patent: **06.12.2023**
(21) Application number: 19197358.5
(22) Date of filing: 13.09.2019
(51) Int. Cl.: H04R 23/00, H04R 19/00, B81B 3/00

(54) **MEMBRANE STRUCTURE, TRANSDUCER DEVICE AND METHOD OF PRODUCING A MEMBRANE STRUCTURE**
MEMBRANSTRUKTUR, WANDLERVORRICHTUNG UND VERFAHREN ZUR HERSTELLUNG EINER MEMBRANSTRUKTUR
STRUCTURE DE MEMBRANE, DISPOSITIF DE TRANSDUCTEUR ET PROCÉDÉ DE PRODUCTION D'UNE STRUCTURE DE MEMBRANE

(43) Date of publication of application: 17.03.2021
(73) Proprietor: ams International AG, 8645 Jona (CH)
(72) Inventor: Heeb, Peter, 9436 Balgach (CH); Müller, Michelle, 9470 Buchs (CH); Stojanovic, Goran, 8640 Rapperswil (CH)
(74) Representative: Epping - Hermann - Fischer

(56) References cited:
- US-A1- 2014 268 273
- US-A1- 2016 023 244
- US-B2- 9 143 870

## Description

The present disclosure relates to a membrane structure, a transducer device and a method for producing a membrane structure.

For membrane-based transducer devices the deflection of the membrane causes a volume change of the volume under the membrane. However, the volume reduction under the membrane leads to a compression of the gas within the volume. Such a compression of gas significantly affects the compliance of the membrane, in particular in miniaturized systems. The compressed gas exerts a restoring force on the membrane, thus preventing a further displacement. However, in most cases a large displacement of the membrane is required to achieve a good sensitivity of the underlying sensor system. This means that for conventional membrane structures the back-volume, beside the membrane stiffness, limits the sensitivity of the system. For this reason, the back-volume has to be chosen as large as possible, which prevents further miniaturization of the device.

US 2016/0023244 A1 discloses a transducer apparatus comprising spring structures that enable a large displacement of the transducer plate. The spring structures comprise spring members, which are connected to anchors via spring junctions. At the spring junction a plug material can be used to secure the junction to the anchor 112.

US 2014/0268273 A1 discloses an elevated aperture layer and display apparatus for optical applications. According to an embodiment, the device can also be used for MEMS microphones. An embodiment shows anchor elements and a thin-film element with corrugations, which is connected to the anchor elements via protrusions.

US 9,143,870 B2 is directed to a microphone system comprising two diaphragms that are mechanically interconnected via beams such that they respond in antiphase to an acoustic signal impinging on one of the diaphragms. A mechanical coupler includes two anchors coupled to the substrate. The anchors support a torsion bar. The torsion bar is flexible and may twist along an axis parallel to the substrate. A beam is arranged on the torsion bar, such that, if one end of the beam moves downwards toward the substrate, the torsion bar twists so that the other end of the beam moves upwards away from the substrate.

It is an objective to provide a membrane structure, which exhibits an increased compliance. It is further an objective to provide a method of producing a membrane structure, which exhibits an increased compliance.

This objective is achieved with the independent claims. Further embodiments and variants derive from dependent claims.

In an embodiment the membrane structure comprises a substrate, which may comprise a semiconductor material, for example silicon (Si). The substrate can have a main plane of extension. The substrate has a main surface and a rear surface. The rear surface faces away from the main surface.

A plurality of pillars are arranged at the main surface of the substrate. The pillars can comprise the same material as the substrate. The pillars can be formed by a part of the substrate at its main surface. The pillars are physically connected to the main surface of the substrate by a base area. In top-view, the shape of the base area is arbitrary. The top-view refers to a view on the membrane structure from the side of the pillars facing away from the substrate in a vertical direction. The vertical direction is perpendicular to the main plane of extension of the substrate. In top-view, the pillars can be arranged along a circle line at the main surface of the substrate. The radius of the circle as well as the number of pillars depends on the application. Neighboring pillars can be arranged equidistant with respect to each other.

For example, the number of pillars can be at least 3 and at most 200. Alternatively, the number of pillars can be at least 4 and at most 50.

With respect to the main plane of extension of the substrate the side surfaces of the pillars can be perpendicular or transverse. Each pillar further comprises a support area facing away from the main surface of the substrate. This means that in the vertical direction each support area has a distance to the main surface of the substrate. The shape of the support area in top-view is arbitrary. The distance from the support area of each pillar to the main surface of the substrate corresponds to the height of the respective pillar. The height can have any value, which is feasible in terms of the aspect ratio of the pillars. The aspect ratio of each pillar is defined by the ratio between its height and its diameter. The diameter of the pillars refers to the lateral extent of the pillars, where lateral directions extend parallel to the main plane of extension of the substrate.

For example, the height of each pillar can be at least 1 µm and at most 100 um. Alternatively, the height of each pillar can be at least 3 µm and at most 10 µm.

The membrane structure further comprises a thin-film structure arranged above the main surface of the substrate and above the pillars. The thin-film structure may comprise a material, which is compatible with a semiconductor process, for example silicon-nitride (SiN) or polycrystalline silicon. The thin-film structure can extend in a plane, which is parallel to the main plane of extension of the substrate. In top-view, the thin-film structure can have any shape. In particular, the shape of the thin-film structure in top-view is circular or poly-angular.

For example, the diameter of the thin-film structure may be at least 100 µm and at most 10 mm. Alternatively, the diameter of the thin-film structure may be at least 500 µm and at most 1 mm.

The thin-film structure comprises a plurality of raised portions that are spaced further from the substrate than at least one lower portion (16) of the thin-film structure. In the vertical direction, the raised portion and the lower portion do not overlap. In lateral directions the raised portion and the lower portion are arranged adjacent to each other. The raised portions are physically connected to the lower portion by a connecting portion of the thin-film structure. With respect to the main plane of extension of the substrate the connecting portion can be perpendicular or transverse.

The lower portion is not in direct mechanical contact with the substrate. However, the lower portion is closer to the substrate than the raised portion. The distance in the vertical direction between the raised portion and the lower portion depends on the application and can differ from one application to another.

For example, the distance between the raised portion and the lower portion can be at least 0.3 µm and at most 10 µm. Alternatively, the distance between the raised portion and the lower portion can be at least 0.6 µm and at most 4 µm.

The raised portions each comprise at least one protruding portion. The protruding portion extends in a vertical direction from the raised portion towards the substrate. The protruding portion is formed by a part of the thin-film structure. The protruding portion has at least one sidewall and a bottom part. The sidewall is perpendicular or transverse with respect to the main plane of extension of the substrate. The bottom part can extend parallel to the main plane of extension of the substrate.

Each protruding portion is arranged directly above a corresponding pillar. The protruding portion mechanically connects the thin-film structure to the support area of a pillar via the bottom part. This means that the bottom part of each protruding portion is in mechanical contact to one of the pillars, respectively, via the support area of the pillar. In top-view, the protruding portion can have any shape. The diameter, which refers to the lateral extent of the bottom part of the protruding portion can be equal to or smaller than the lateral extent of the support area of the corresponding pillar.

For example, the diameter of the bottom part of the protruding portions can be at least 0.5 µm and at most 50 µm. Alternatively, the diameter of the bottom part can be at least 2 µm and at most 15 µm.

The protruding portion is hollow. This means that the protruding portion forms a hollow profile. The volume enclosed by the protruding portion is delimited by the bottom part and the at least one sidewall of the protruding portion. At the top side of the protruding portion, the enclosed volume is connected to the environment above the thin-film structure. This means, the protruding portion is open at the top side.

A back-volume is formed by the volume between the main surface of the substrate and the thin-film structure. This means that the volume, which is delimited by the substrate on the one side and by the thin-film structure on the other side forms the back-volume of the device. The back-volume can be filled with air or a gas. The back-volume can be connected to the environment.

The plurality of pillars and protruding portions can be arranged in a specific way. For example in top-view, the pillars and protruding portions can be arranged along a circle line, whereas the thin-film structure also can have a circular shape with a larger diameter and both circles are concentric. By this arrangement, a center part and an outer part of the thin-film structure is defined. The center part of the thin-film structure refers to a region of the thin-film structure, which lies within the circle line the pillars and the protruding portions are arranged at in top-view. The outer part of the thin-film structure refers to the outer ring of the thin-film structure, which lies outside of the circle line the pillars and the protruding portions are arranged at in top-view. Also, a distribution of the back-volume into two back-chamber compartments is provided this way. An inner back-chamber compartment is formed by the back-volume between the center part of the thin-film structure and the substrate. An outer back-chamber compartment is formed by the volume between the outer part of the thin-film structure and the substrate.

Because of the used material, its thickness and the specific arrangement, the thin-film structure is a movable part. Thus, the thin-film structure forms a membrane, which is only connected to the substrate via the protruding portions and the pillars. This means that the thin-film structure is capable to become deflected. The deflection of the membrane can be in vertical directions towards the substrate and/or away from the substrate.

Each pair of pillars and protruding portions forms a mechanical phase shifter during membrane deflection. This means that a mechanical phase shifter comprises a pillar and a protruding portion each. The phase shift between parts of the membrane, which move towards the substrate and other parts of the membrane, which move away from the substrate, is 180°. For example, when the center part of the membrane moves towards the substrate, the outer part of the membrane moves away from the substrate. Thus, the membrane movement is driven in a push-and-pull mode, whereas one part of the membrane is directly coupled (0° phase shift) and the other part is coupled by a 180° phase shift to a driving force. The driving force can be, for example, a sound pressure wave.

The effect of the mechanical phase shifters is that the back-volume under the membrane does not change much or even stays equal under deflection. For example, when the center part of the membrane moves towards the substrate, the volume below the center part becomes smaller. At the same time the outer part of the membrane moves away from the substrate, which enlarges the volume below the outer part. The movement can also be performed vice versa. There is a net volume flow between the two back-chamber compartments, depending on the deflection of the membrane. Because of the net volume flow the gas compression is reduced, which in turn leads to an increased system compliance. Due to the mechanical phase shifters the back-volume can be small, which allows further miniaturization of the system. For an increased compliance and a reduced back-volume a membrane structure can comprise several mechanical phase shifters at user-defined locations, for example along lines within the outline of the membrane structure. The cross-section, number and arrangement of these mechanical phase shifters can be chosen in such a way that the compliance is maximized.

The pillars and the protruding portions of the thin-film structure are arranged at a predetermined distance to an outer edge of the thin-film structure. All pillars and all protruding portions
can have the same predetermined distance to the outer edge of the thin-film structure. For example, if the thin-film structure is circular, each pillar and each protruding portion can be arranged at a distance to the outer edge of the thin-film structure of one-third of the radius of the thin-film structure. This way, the pillars and the protruding portions are arranged along a circle line in top-view. However, the pillars and the protruding portions can also be arranged closer to the outer edge or closer to the center of the thin-film structure.

Certain predetermined distances of the pillars and the protruding portions can enable higher order Eigen mode operation of the membrane. This way the resonance frequency of the membrane can be shifted to higher values and certain lower order modes can be prevented.

In a further embodiment of the membrane structure each raised portion is completely surrounded by the at least one lower portion in lateral directions. Thus, each raised portion is limited to a comparatively small region within the thin-film structure. The raised portions can be arranged above regions, where a pillar at the main surface of the substrate is present. In top-view, the diameter of each raised portion can be larger than the diameter of such corresponding pillar. Thus, a protruding portion, which is comprised by the raised portion, can be mechanically connected to the underlying pillar. Each raised portion is connected to the at least one lower portion by a connecting portion at all lateral sides. The connecting portion can be vertical or transverse with respect to the main plane of extension of the substrate.

This construction allows a flexible bending of the membrane during deflection. The raised portion and the protruding portion provide a flexible joint, so that the membrane can swing as freely as possible. The deformation of the thin-film structure during the deflection mainly takes place in regions of the sidewalls of the protruding portions and in regions of the connecting portions. The bending of the membrane at the protruding portions dominates the membrane sensitivity. Thus, the sensitivity can be increased by optimization of the protruding portions in terms of shape and film thickness by way of example.

In a further embodiment of the membrane structure each raised portion extends to the outer edge of the thin-film structure. Each raised portion is connected to the at least one lower portion by a connecting portion at all lateral sides, apart from the side facing the outer edge of the thin-film structure. The connecting portion can be vertical or transverse with respect to main plane of extension of the substrate. Each raised portion has an elongated shape in top-view, reaching from the outer edge of the thin-film structure towards one corresponding pillar. Within each raised portion there is a protruding portion connecting the thin-film structure to the pillar.

By this arrangement the bending of the membrane during deflection is flexible, since the raised portion and the protruding portion provide a flexible joint. The outer part of the membrane is constructed more rigidly. Lower portions and raised portions are alternating at the outer part of the membrane, thus forming a corrugation. The corrugation provides an enhanced stiffness of the outer part of the membrane and prevents the membrane from sagging.

In one embodiment of the membrane structure at least one enclosing wall is arranged on the main surface of the substrate at a distance to the outer edge of the thin-film structure. The enclosing wall surrounds the thin-film structure in lateral directions. The enclosing wall can comprise the same material as the substrate. The enclosing wall can be formed by a part of the substrate at its main surface. The enclosing wall is mechanically connected to the main surface of the substrate. The enclosing wall further comprises side surfaces. The side surfaces can be perpendicular with respect to the main plane of extension of the substrate. The enclosing wall further comprises a top surface. The top surface of the enclosing wall can extend in a plane, which runs parallel to the main plane of extension of the substrate.

The top surface of the enclosing wall has a distance to the main surface of the substrate, which corresponds to the height of the enclosing wall. The enclosing wall can be as high as the thin-film structure. This means that in the vertical direction the distance from the top surface of the enclosing wall to the main surface of the substrate can be the same as the distance from the lower portion of the thin-film structure to the main surface of the substrate. Alternatively, the distance in the vertical direction from the top surface of the enclosing wall to the main surface of the substrate can be the same as the distance from a raised portion of the thin-film structure to the main surface of the substrate.

The enclosing wall surrounds the thin-film structure in lateral directions. This means that the enclosing wall can form a ring around the thin-film structure in top view. There is a slit between the enclosing wall and the thin-film structure in lateral directions. This means that the inner diameter of the ring formed by the enclosing wall is larger than the diameter of the thin-film structure.

The difference between these diameters, which means the size of the slit between the enclosing wall and the thin-film structure can be at least 0.1 µm and at most 5 µm. Alternatively, the size of the slit can be at least 0.5 µm and at most 1 µm.

By arranging an enclosing wall around the thin-film structure the back-volume of the membrane structure becomes enclosed in lateral directions. Thus, the back-volume of the membrane structure is connected to the environment only by the slit between the enclosing wall and the thin-film structure. This way, a bypass between the back-volume and the environment is prevented. If, in particular, the membrane structure acts as a microphone or a speaker membrane of an acoustic device, an acoustic short-circuit between both sides of the membrane is avoided by the enclosing wall. To increase the acoustic impedance of the slit between the enclosing wall and the membrane the slit can be chosen as small as possible. Besides, a small slit leads to an omnidirectional microphone device comprising the membrane structure, since a sound pressure wave can impact only on the side of the membrane facing away from the substrate.

In a further embodiment of the membrane structure the thin-film structure is connected to the enclosing wall by at least one elastic layer. The elastic layer may comprise any material with a low value for its Young's modulus in comparison with the Young's modulus for the material used for the thin-film structure and the enclosing wall. For example, the elastic layer may comprise polydimethylsiloxane (PDMS). The elastic layer can form a ring, which spans the slit between the enclosing wall and the thin-film structure. The elastic layer covers a part of the thin-film structure at the side facing away from the substrate as well as a part of the top surface of the enclosing wall. Thus, the elastic layer is mechanically connecting the thin-film structure to the enclosing wall.

The acoustic impedance of the slit between the enclosing wall and the thin-film structure can be further increased by the elastic layer. This way, the back-volume under the membrane is completely enclosed and not connected to the environment above the membrane. Thus, an acoustic short-circuit between both sides of the membrane is avoided. Additionally, because of its low Young's modulus, the elastic layer can be stretched allowing the membrane to move relatively freely.

In a further embodiment of the membrane structure the elastic layer is gas-permeable. This means that gas particles at both sides of the membrane, which means in the vertical direction below and above the membrane, can diffuse through the elastic layer.

By the gas-permeability of the elastic layer, though the back-volume under the membrane is enclosed, a gas flow between both sides of the membrane can be established. The gas flow provides a pressure equalization between the back-volume and the environment. This can be necessary since due to the membrane deflection the change of gas density within the back-volume can affect the system compliance and thus the dynamic characteristics of the membrane structure.

In a further embodiment the membrane structure comprises an opening in the substrate extending from the rear surface of the substrate towards the thin-film structure. The opening is formed as a trench extending within the substrate in the vertical direction. The opening can have a smaller extent in the lateral directions than the thin-film structure. The opening can connect the back-volume, which is formed between the substrate and the thin-film structure, to the environment at the rear surface of the substrate. The opening can have any shape. The depth of the opening in vertical direction is given by the thickness of the substrate.

By forming the opening an access is given from the rear surface to the main surface of the substrate. An access can be necessary for processing reasons, for example for removing a sacrificial layer region. Besides, by forming an opening the back-volume is enlarged. This can be important, too, for example for microphone applications, since the response of a membrane to sound waves, especially at audio frequencies, can be changed by increasing the back-volume. The sensitivity as well as the signal-to-noise ratio can be improved, since the acoustic compliance given by the back-volume is enlarged. Moreover, optical reading of the membrane displacement becomes possible by the opening. In this case light coming from the rear surface, for example from an attached photonics wafer, can pass through the opening, reach the membrane and be reflected towards a light sensor and/or a photo detector.

In a further embodiment the membrane structure comprises a vent hole within the thin-film structure. The vent hole can be arranged in the center of the thin-film structure with respect to the lateral extent of the thin-film structure. The vent hole connects both sides of the thin-film structure to each other. This means that the vent hole connects the side of the thin-film structure, which faces towards the substrate, to the side of the thin-film structure, which faces away from the substrate. The vent hole can have a small diameter compared with the diameter of the thin-film structure.

Through the vent hole, a gas flow between both sides of the membrane can be established. The gas flow provides a pressure equalization between the back-volume and the environment. This can be necessary since due to the membrane deflection the change of gas density within the back-volume can affect the system compliance and thus the dynamic characteristics of the membrane structure.

In a further embodiment of the membrane structure the thin-film structure has a circular or poly-angular shape in top-view. This means that the thin-film structure has a central point. In lateral directions the thin-film structure is point-symmetric with respect to the central point. However, the shape of the thin-film structure is not limited to being circular or poly-angular, but can have any shape, for example a rectangular or elliptic shape.

A circular or poly-angular shape of the thin-film structure used as membrane, for example, is advantageous in terms of a uniform deflection and a uniform stress distribution in lateral directions.

In a further embodiment the membrane structure is incorporated in a transducer device. The transducer device can be in particular an omnidirectional optical microphone. An omnidirectional microphone is capable to respond to sound from all directions, even to sound arriving from a rear side. The microphone can further be an optical microphone. An optical microphone evaluates the response of a membrane to sound by use of an optical method. When a mirror is integrated on the membrane, vibrations can be detected by use of a laser beam and an interferometer. This way, movements of the membrane can be detected by changes in the optical path length of the reflected beam. In this arrangement there is advantageously no need for a back plate, as needed for conventional condenser microphones. However, the transducer device can also be any other dynamic pressure sensing device.

In a further embodiment a plurality of membrane structures are incorporated in a transducer device such as a microphone or a pressure sensor. The plurality of membrane structures can be arranged in a repeated construction, so that it forms an array of membrane structures. This way, the transducer device enables array sensing.

In a further embodiment the transducer device comprising the membrane structure is incorporated in an electric device. The electric device can be, for example, a smart speaker device, a smart watch, a phone or a hearing aid device. Since the membrane structure can be fabricated by a technology for microelectromechanical systems (MEMS) and can have a reduced back-volume the mobile device may have small dimensions.

Furthermore, a method of producing a membrane structure is provided. All features disclosed for the membrane structure are also disclosed for the method for producing the membrane structure and vice-versa.

The method of producing a membrane structure comprises providing a substrate. Pillars are formed by an etching step at the top surface of the substrate. The etching step can be, for example, deep reactive-ion etching (DRIE). The etching step can be performed time-controlled in order to reach a certain height of the pillars. By forming pillars a back-volume for the resulting membrane structure is generated. The pillars provide support areas for the thin-film structure.

After forming the pillars a sacrificial layer region is arranged in places at the main surface of the substrate and on the pillars. The sacrificial layer region can comprise, for example, tungsten-titanium (W-Ti) and can be deposited, for example, by a sputter process. Patterning of the sacrificial layer region can be done by etching. Several depositions of sacrificial layers can be conducted subsequently and after each deposition an etching process can be performed for patterning the corresponding sacrificial layer. The stack of sacrificial layers then forms the sacrificial layer region. The sacrificial layer region provides at least a first thickness level and a second thickness level. The first thickness level is larger than the second thickness level. A plurality of trenches within regions with the first thickness level is formed, where each trench extends to one of the pillars, respectively. In top-view, the diameter of the trench can be equal to or smaller than the diameter of the pillar.

A thin-film is deposited on the sacrificial layer region and the plurality of trenches. The thin-film may be deposited by chemical vapor deposition (CVD) or plasma enhanced CVD (PECVD). The thin-film can be patterned by an etching process. The thin-film is in mechanical contact with the support area of each pillar, namely at the bottom of the trench in the sacrificial layer region. Besides, the thin-film covers the side surfaces of the trench in the sacrificial layer region. The thin-film also covers the edges of the trench in the sacrificial layer region. The thin-film also covers the top surface of the sacrificial layer region, this means the surface of the sacrificial layer region facing away from the substrate. Thus, the sacrificial layer region is arranged between the substrate and the thin-film.

After the deposition of the thin-film and its patterning the sacrificial layer region is removed. In this way a thin-film structure is formed from the thin-film by removing the sacrificial layer region. The removal of the sacrificial layer region can be done by wet etching. The etchant can access to the sacrificial layer region through openings in the substrate or in the thin-film or by regions, which are not covered by the thin-film. The removal of the sacrificial layer region releases the thin-film. This means that a raised portion of the thin-film is formed after the removal of the sacrificial layer region, where the thin-film has been deposited on the first thickness level. A protruding portion is formed by the part of the thin-film deposited within one of the plurality of trenches in the sacrificial layer region. A connecting portion of the thin-film structure is formed by the part of thin-film deposited between the first thickness level and the second thickness level. A lower portion is formed by the part of the thin-film deposited on the second thickness level. The membrane structure is formed by the thin-film, the pillars, the substrate and the back-volume formed by the cavity left after the removal of the sacrificial layer region.

By using a sacrificial layer region free-standing thin-film structures can be produced. Processes of making free-standing thin-film structures are simpler and more cost-effective than equivalent structures made with processes like chemical mechanical polishing (CMP). Additionally, by adding protruding portions, which are in mechanical contact to support areas of underlying pillars, mechanical phase shifters can be introduced for a push-and-pull mode operation during membrane deflection.

In one embodiment of the method of producing a membrane structure at least one enclosing wall is formed by an etching step at the main surface of the substrate. The etching step can be the same as the etching step for forming the pillars. However, the etching step can also be performed before or after forming the pillars. Alternatively, several etching steps can be combined to form both the pillars and the enclosing wall. For example, deep reactive-ion etching (DRIE) can be used. The etching can be performed in such a way, that the pillars and the enclosing wall have the same height with respect to the main surface of the substrate. However, the height of the pillars and the enclosing wall can also be different.

By forming an enclosing wall the back-volume of the membrane structure becomes enclosed in lateral directions, which increases the acoustic impedance of the resulting membrane structure.

In one embodiment of the method of producing a membrane structure an elastic layer is deposited, the elastic layer mechanically connecting the thin-film structure to the enclosing wall. The elastic layer can comprise PDMS by way of example. The elastic layer can be deposited, for example, by coating or 3D-printing. The deposition can take place before or after the removal of the sacrificial layer region. The elastic layer covers a region on the top surface of the enclosing wall and a region of the side of the thin-film structure facing away from the substrate. Thus, the elastic layer can form a ring, which spans the slit between the enclosing wall and the thin-film structure.

The acoustic impedance of the slit between the enclosing wall and the thin-film structure can be further increased by the elastic layer. This way, the back-volume under the membrane is completely enclosed and not connected to the environment above the membrane. Thus, an acoustic short-circuit between both sides of the membrane is avoided. Additionally, because of its low Young's modulus, the elastic layer can be stretched allowing the membrane to move relatively freely.

In one embodiment of the method of producing a membrane structure an opening in the substrate is formed. The opening can be formed by deep reactive-ion etching (DRIE). The opening extends from the rear surface of the substrate towards the thin-film structure. The etching process can be controlled by time or by use of an etch stop layer. In the latter case the etch stop layer has been deposited before the deposition of the sacrificial layer region at the main surface of the substrate in places, where the opening shall be formed. The etch stop layer may comprise chrome (Cr) and can be removed after forming the opening for example by wet etching. The lateral extent of the opening can be smaller than the lateral extent of the thin-film structure.

By forming an opening an access is given from the rear surface to the main surface of the substrate. An access can be necessary for processing reasons, for example for removing the sacrificial layer region. Besides, by forming an opening the back-volume between the substrate and the thin-film structure can be increased. This means that the back-volume is enlarged in a vertical direction through the opening in the substrate. This can be important, too, for example for microphone applications, since the response of a membrane to sound waves, especially at audio frequencies, can be changed this way. Thus, the sensitivity as well as the signal-to-noise ratio can be improved by enlarging the back-volume. Moreover, optical reading of the membrane displacement becomes possible by the opening. In this case light coming from the rear surface, for example from an attached photonics wafer, can pass through the opening, reach the membrane and be reflected towards a light sensor and/or photodetector.

In one embodiment of the method of producing a membrane structure the sacrificial layer region is removed after forming the opening in the substrate. In some embodiments the opening can give the only access to the sacrificial layer region, since above the top surface of the substrate the sacrificial layer region is covered by the thin-film. The access can then be used for removing the sacrificial layer region, for example by wet etching.

The following description of figures may further illustrate and explain exemplary embodiments. Components that are functionally identical or have an identical effect are denoted by identical references. Identical or effectively identical components might be described only with respect to the figures where they occur first. Their description is not necessarily repeated in successive figures.
Figures 1a to 1b show a cross-section and an equivalent acousto-electrical circuit of an example for a membrane-based acoustic device.
Figures 2a to 2b show a cross-section and an equivalent acousto-electrical circuit of an embodiment of a membrane structure.
Figure 3 shows two cross-sections of an embodiment of a membrane structure.
Figure 4 shows a cross-section and a top-view of another embodiment of a membrane structure.
Figure 5 shows a cross-section and a top-view of another embodiment of a membrane structure.
Figure 6 shows a cross-section and a top-view of another embodiment of a membrane structure.
Figure 7 shows a cross-section and a top-view of another embodiment of a membrane structure.
Figure 8 shows a cut-away view of another embodiment of a membrane structure.
Figure 9 shows a schematic diagram of an exemplary embodiment of a transducer device, the transducer device comprising a membrane structure.
Figures 10a to 10f show an embodiment of a method of producing a membrane structure.

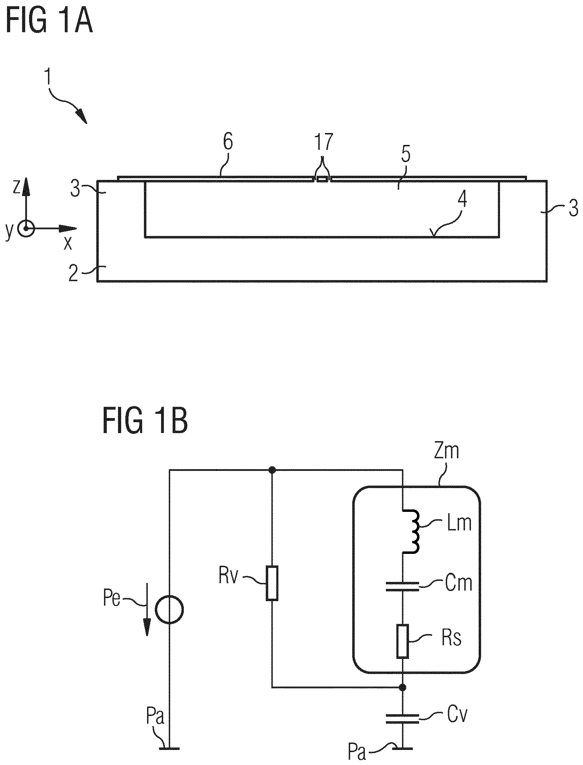

In Figure 1a a cross-section of an example of a membrane structure 1, which is no embodiment, is shown. The membrane structure 1 is arranged in a conventional way. The membrane structure 1 comprises a substrate 2. An enclosing wall 3 is arranged at a main surface 4 of the substrate 2. The enclosing wall 3 surrounds a back-volume 5 in lateral directions x, y, where lateral directions run parallel to a main plane of extension of the substrate 2.

The membrane structure 1 further comprises a thin-film structure 6 above the main surface 4 of the substrate 2 attached to the enclosing wall 3. This means that the thin-film structure 6 is in mechanical contact to the enclosing wall 3. The thin-film structure 6 is spaced from the substrate 2 in a vertical direction z, where the vertical direction z is perpendicular to the main plane of extension of the substrate 2. The thin-film structure 6 spans the back-volume 5. This means that the back-volume 5 is enclosed by the substrate 2, the enclosing wall 3 and the thin-film structure 6. The thin-film structure 6 comprises a vent hole 7. The vent hole 7 is an opening in the thin-film structure 6, which connects the side of the thin-film structure 6 facing towards the substrate 2 to the side of the thin-film structure 6 facing away from the substrate 2. The vent hole 7 connects the back-volume 5 to the environment above the thin-film structure 6. The thin-film structure 6 can act as a membrane responding to a sound pressure wave. This way, the membrane structure 1 can be used for acoustic applications such as microphone or speaker applications.

In Figure 1b an equivalent acousto-electrical circuit of the example of Figure 1a is shown. In an equivalent acousto-electrical circuit symbols are assigned to the acoustic components of a device, as known for an electrical circuit.

The equivalent acousto-electrical circuit of Figure 1b comprises a common pressure level Pa and an external source of sound pressure Pe, which acts as a driving force for the deflection of the membrane. The membrane is represented in the equivalent acousto-electrical circuit of Figure 1b by a complex acoustic impedance Zm of the membrane, which comprises an acoustic mass Lm of the membrane, an acoustic compliance Cm of the membrane and an acoustic resistance Rs of the gas film under the membrane. The acoustic mass Lm of the membrane corresponds to the inertia of the membrane deflecting due to the sound pressure Pe. The acoustic compliance Cm of the membrane corresponds to the stiffness of the membrane, which provides a restoring force. The acoustic resistance Rs of the gas film under the membrane corresponds to the film of gas, which gets squeezed due to the movement of the membrane. Furthermore, Figure 1b comprises a further acoustic resistance Rv, which represents the vent hole 7 of the membrane. The vent hole 7 leads to the further acoustic resistance Rv due to its limited diameter the sound pressure has to pass through. Besides, the equivalent acousto-electrical circuit comprises an acoustic compliance Cv of the back-volume 5. The acoustic compliance Cv of the back-volume 5 represents the gas within the back-volume 5, which gets compressed under the deflection of the membrane. Thus, the compressed gas also acts as a restoring force.

The acoustic mass Lm of the membrane, the acoustic compliance Cm of the membrane and the acoustic resistance Rs of the gas film under the membrane are connected in series to form the complex acoustic impedance Zm of the membrane. The further acoustic resistance Rv of the vent hole 7 is connected in parallel to the complex acoustic impedance Zm of the membrane. The acoustic compliance Cv of the back-volume 5 is connected in series to both the further acoustic resistance Rv of the vent hole 7 and the complex acoustic impedance Zm of the membrane and is further connected to the common pressure level Pa. The external source of sound pressure Pe is connected to all those components in series and is further connected to the common pressure level Pa.

In this arrangement the further acoustic resistance Rv of the vent hole 7 and the acoustic compliance Cv of the back-volume 5 form a high pass filter. The acoustic compliance Cv of the back-volume 5 and the acoustic compliance Cm of the membrane form an acoustic compliance divider.

This means that at the low frequencies, displacement of the membrane is limited by the high pass filter. However, at audio frequencies, the membrane displacement is limited by the acoustic compliance divider. To achieve a membrane displacement as large as possible the acoustic compliance Cv of the back-volume 5 has to be large. Such request requires a large back-volume 5.

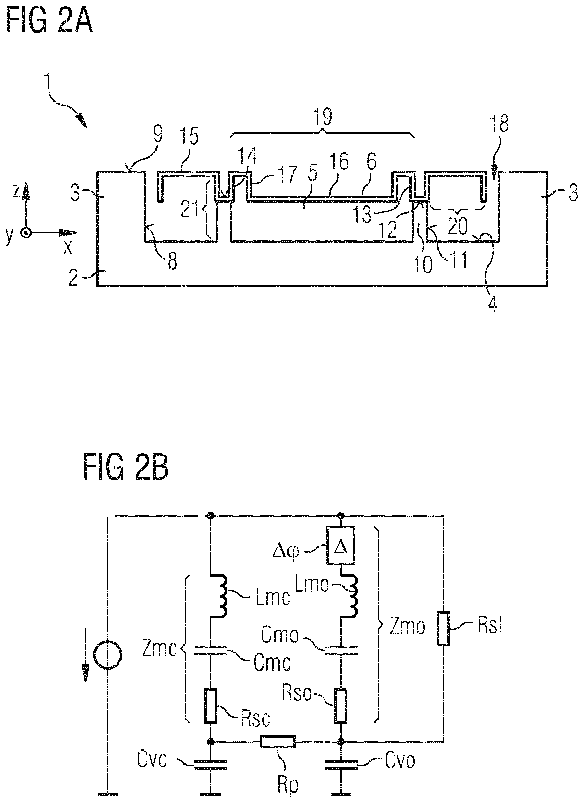

In Figure 2a a cross-section of an embodiment of a membrane structure 1 is shown. Elements according to Figure 2a that correspond to elements of the examples according to Figures 1a are designated with the same reference numerals. The embodiment according to Figure 2a comprises a substrate 2 with a main surface 4. The substrate 2 has a main plane of extension. As in Figure 1a an enclosing wall 3 is arranged at the main surface 4 of the substrate 2. The enclosing wall 3 can be formed by a part of the substrate 2 and is in mechanical contact with the substrate 2. The enclosing wall 3 further comprises a side surface 8, which can be perpendicular to the main plane of extension of the substrate 2 as well as a top surface 9, which runs parallel to the main plane of extension of the substrate 2. In the vertical direction z, which is perpendicular to the main plane of extension of the substrate 2, the top surface 9 of the enclosing wall 3 is spaced from the main surface 4 of the substrate 2. The enclosing wall 3 surrounds a back-volume 5 in lateral directions x, y, which run parallel to the main plane of extension of the substrate 2.

Additionally, pillars 10 are arranged at the main surface 4 of the substrate 2 within the back-volume 5. The pillars 10 can be formed by a part of the substrate 2 and are in mechanical contact with the substrate 2. The pillars 10 comprise a side surface 11, which can be perpendicular to the main plane of extension of the substrate 2 as well as a support area 12, which runs parallel to the main plane of extension of the substrate 2. In the vertical direction z, the support area 12 of the pillars 10 is spaced from the main surface 4 of the substrate 2. However, in this embodiment, the distance from the support area 12 of the pillars 10 to the main surface 4 of the substrate 2 is less than the distance from the top surface 9 of the enclosing wall 3 to the main surface 4 of the substrate 2. In lateral directions x, y the pillars 10 are arranged at a distance to the enclosing wall 3.

The embodiment of Figure 2a further comprises a thin-film structure 6 above the main surface 4 of the substrate 2 and above the pillars 10. The thin-film structure 6 is spaced from the substrate 2. The thin-film structure 6 extends in a plane, which runs parallel to the main plane of extension of the substrate 2. The thin-film structure 6 covers the back-volume 5. However, the thin-film structure 6 is not connected to the enclosing wall 3. Instead, the thin-film structure 6 is connected to the pillars 10 by protruding portions 13. This means that a bottom part 14 of each protruding portion 13 is in mechanical contact with the support area 12 of a corresponding pillar 10. The thin-film structure 6 further comprises raised portions 15, from which each protruding portion 13 extends towards a corresponding pillar 10. The raised portions 15 are spaced further from the substrate 2 than lower portions 16 of the thin-film structure 6. Raised portions 15 and lower portions 16 are connected by connecting portions 17 of the thin-film structure 6. Because the thin-film structure 6 is not connected to the enclosing wall 3 there is a slit 18 between both components. This means that the slit 18 connects the back-volume 5 with the environment above the thin-film structure 6. However, the slit 18 can be small.

As in the example of Figure 1a, the thin-film structure 6 can act as a membrane responding to a sound pressure wave. In this case the membrane can be regarded to have a center part 19 and an outer part 20. The center part 19 of the membrane is the part which lies, in a top-view, within the pillars 10. The outer part 20 of the membrane is the part which lies, in a top-view, between the enclosing wall 3 and the pillars 10. The top-view refers to a view on the membrane structure 1 from the side of the membrane facing away from the substrate 2 in the vertical direction z.

Due to this arrangement the membrane is deflected by a sound pressure wave in the following way. While the center part 19 of the membrane is moving towards the substrate 2 the outer part 20 of the membrane is moving away from the substrate 2 and vice versa. This means that while the back-volume 5 under the center part 19 of the membrane becomes smaller, the back-volume 5 under the outer part 20 of the membrane enlarges and vice versa. This means that the pillars 10 and the protruding portions 13 form mechanical phase shifters 21 providing a phase shift between the outer part 20 and the center part 19 of the membrane of 180°.

In Figure 2b an equivalent acousto-electrical circuit for the embodiment of a membrane structure 1 according to Figure 2a is shown. Figure 2b is different from Figure 1b in that it shows two branches for a complex acoustic impedance Zm of the membrane. The first branch comprises the complex acoustic impedance Zmc of the center part 19 of the membrane. The complex acoustic impedance Zmc of the center part 19 of the membrane comprises an acoustic mass Lmc of the center part 19 of the membrane, an acoustic compliance Cmc of the center part 19 of the membrane and an acoustic resistance Rsc of the gas film squeezed by the center part 19 of the membrane. The second branch comprises the complex acoustic impedance Zmo of the outer part 20 of the membrane. The complex acoustic impedance Zmo of the outer part 20 of the membrane comprises an acoustic mass Lmo of the outer part 20 of the membrane, an acoustic compliance Cmo of the outer part 20 of the membrane and an acoustic resistance Rso of the gas film squeezed by the outer part 20 of the membrane. Besides, the second branch comprises a phase shifter Δϕ, which respects the fact that the center part 19 of the membrane and the outer part 20 of the membrane are moving inversely phased.

The two branches are coupled by an acoustic resistance Rp, which corresponds to the acoustic resistance caused by the pillars 10 within the back-volume 5 and which represents the damping of the membrane. The acoustic resistance Rv of the vent hole 7 in Figure 1b is replaced in Figure 2b by the acoustic resistance Rsl of the slit 18 between the enclosing wall 3 and the membrane. Besides, the equivalent acousto-electrical circuit of Figure 2b comprises an acoustic compliance Cvc of the back-volume 5 under the center part 19 of the membrane as well as an acoustic compliance Cvo of the back-volume 5 under the outer part 20 of the membrane.

Since the deflection of the membrane causes a volume flow between the back-volume 5 under the center part 19 of the membrane and the back-volume 5 under the outer part 20 of the membrane, there is a reduced gas compression. Consequently, the restoring force on the membrane is small. Consequently, even with a small back-volume 5, the acoustic compliances Cvc, Cvo of the back-volume 5 are large.

At low frequencies, the time constant of an acoustic device based on the membrane structure 1 of Figures 2a and 2b is determined by the acoustic resistances Rsl and Rp as well as by the acoustic compliances Cvc and Cvo. In order to achieve a low high pass cut-off frequency the acoustic resistance Rsl of the slit 18 has to be as large as possible. This way, a pressure drop is avoided and the noise level of the acoustic device can be reduced. The acoustic resistance Rsl of the slit 18 can be increased, for example, by reducing the size of the slit 18, which means the distance of the membrane to the enclosing wall 3.

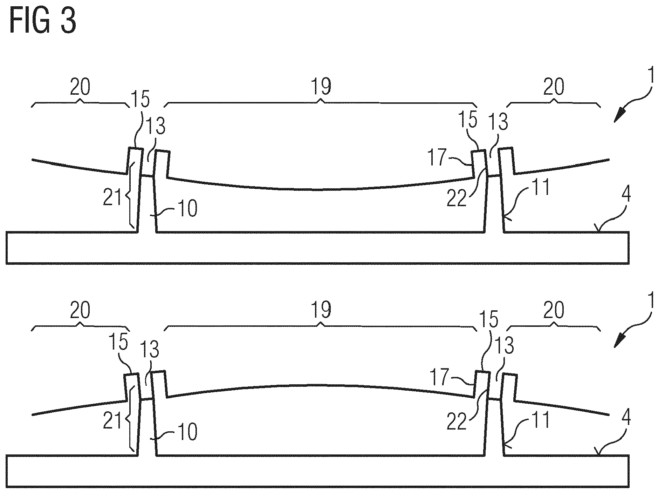

In Figure 3 two cross-sections of another embodiment of the membrane structure 1 are shown. Figure 3 differs from Figure 2a in that in does not show an enclosing wall 3 at the main surface 4 of the substrate 2. Besides, the side surface 11s of the pillars 10 are transverse with respect to the main plane of extension of the substrate 2.

Figure 3 shows two states of deflection of the membrane caused by, for example, a sound pressure wave. In the first case the center part 19 of the membrane is deflected towards the substrate 2, whereas the outer part 20 of the membrane is deflected away from the substrate 2. In the second case the center part 19 of the membrane is deflected away from the substrate 2, whereas the outer part 20 of the membrane is deflected towards the substrate 2. Each pair of pillars 10 and protruding portions 13 forms a mechanical phase shifter 21, which causes the inverted phase between the motion of the center part 19 of the membrane and the motion of the outer part 20 of the membrane. The raised portion 15 and the protruding portion 13 provide a flexible joint, so that the membrane can swing as freely as possible. The deformation of the membrane during the deflection mainly takes place in regions of the sidewalls 22 of the protruding portions 13 and in regions of the connecting portions 17.

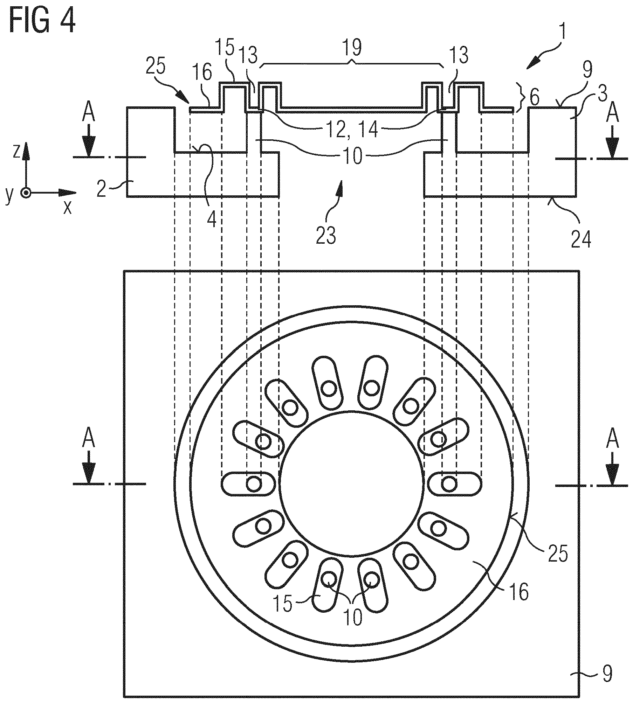

In Figure 4 a cross-section and a top-view of another embodiment of the membrane structure 1 are shown. The cross-section shows the membrane-structure along a cut A-A as indicated in the top-view. Measures in the cross-section, which correspond to measures in the top-view, are indicated by vertical dotted lines.

The cross-section in Figure 4 differs from the cross-section in Figure 2b inter alia in that it shows an opening 23 in the substrate 2. The opening 23 extends in the vertical direction z from a rear surface 24 of the substrate 2 towards the thin-film structure 6. The opening 23 has a smaller extent in lateral directions x, y than the center part 19 of the thin-film structure 6. Besides, the top surface 9 of the enclosing wall 3 has the same height as the support area 12 of the pillars 10, where the height is the distance to the main surface 4 of the substrate 2 in the vertical direction z. In comparison with Figure 2a the raised portions 15 of the thin-film structure 6 of Figure 4 have a smaller extent in lateral directions x, y. This means that each raised portion 15 is completely surrounded by the lower portion 16, as visible in the top-view diagram of Figure 4. The lower portion 16 of the thin-film structure 6 extends to the outer edge 25 of the thin-film structure 6. Thus, at the outer edge 25 of the thin-film structure 6, the thin-film structure 6 has the same height as the top surface 9 of the enclosing wall 3. In the embodiment of Figure 4 the thin-film structure 6 has a circular shape in top-view. A plurality of pillars 10 are arranged along a circle line at a predetermined distance to the outer edge 25 of the thin-film structure 6. This means that the circle line the pillars 10 are arranged on is concentric to the circular thin-film structure 6, but has a smaller diameter. The raised portions 15 are arranged above the pillars 10, but have a larger extent in lateral directions x, y than the pillars 10. Each raised portion 15 comprises a protruding portion 13, which extends towards a corresponding pillar 10 mechanically connecting the support area 12 of the pillar 10 by a bottom part 14.

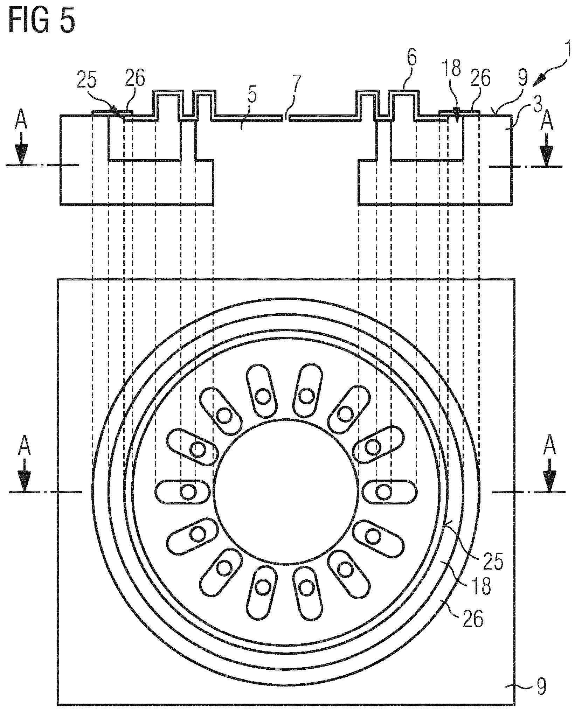

In Figure 5 a cross-section and a top-view of another embodiment of the membrane structure 1 are shown. The cross-section shows the membrane-structure along a cut A-A as indicated in the top-view. Measures in the cross-section, which correspond to measures in the top-view, are indicated by vertical dotted lines.

Figure 5 differs from Figure 4 in that it shows an additional elastic layer 26 connecting the thin-film structure 6 to the enclosing wall 3. This means that the elastic layer 26 is mechanically connected to a part of the top surface 9 of the enclosing wall 3 as well as to a part of the thin-film structure 6 at its outer edge 25. Thus, the elastic layer 26 covers the slit 18 between the thin-film structure 6 and the enclosing wall 3. The elastic layer 26 increases the acoustic resistance Rsl of the slit. The elastic layer 26 can be stretched so that the thin-film structure 6 can still act as a membrane, i.e. can be deflected, for example by a sound pressure wave.

The thin-film structure 6 of the embodiment of Figure 5 additionally comprises a vent hole 7 in the center of the thin-film structure 6. The vent hole 7 is provided for pressure equalization between the environment above the thin-film structure 6 and the back-volume 5. In case that the elastic layer 26 is gas-permeable, the vent hole 7 can be omitted.

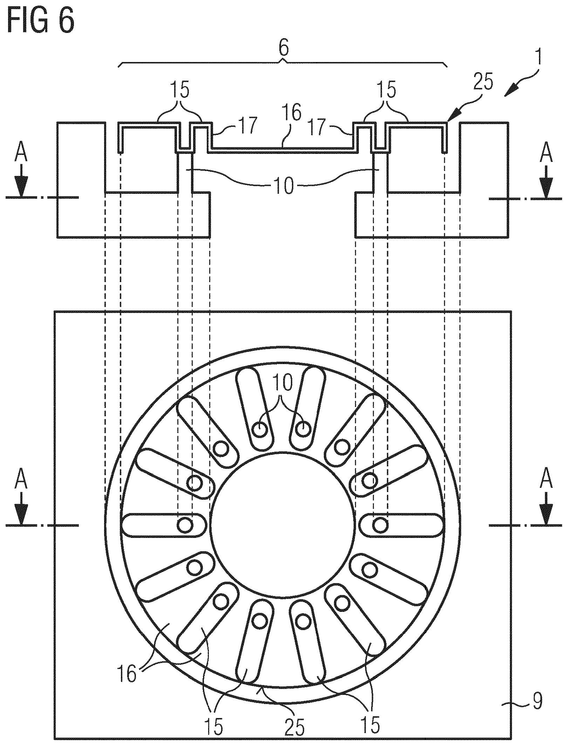

In Figure 6 a cross-section and a top-view of another embodiment of the membrane structure 1 are shown. The cross-section shows the membrane-structure along a cut A-A as indicated in the top-view. Measures in the cross-section, which correspond to measures in the top-view, are indicated by vertical dotted lines.

Figure 6 differs from Figure 4 in that it comprises raised portions 15 which extend to the outer edge 25 of the thin-film structure 6. Each raised portion 15 is connected to the lower portion 16 by a connecting portion 17 at all lateral sides, apart from the side facing the outer edge 25 of the thin-film structure 6. This means that the lateral extent of the raised portion 15 in this embodiment is larger than the lateral extent of the raised portion 15 in the embodiment according to Figure 4. The raised portions 15 have an elongated shape, reaching from the outer edge 25 of the thin-film structure 6 towards a corresponding pillar 10.

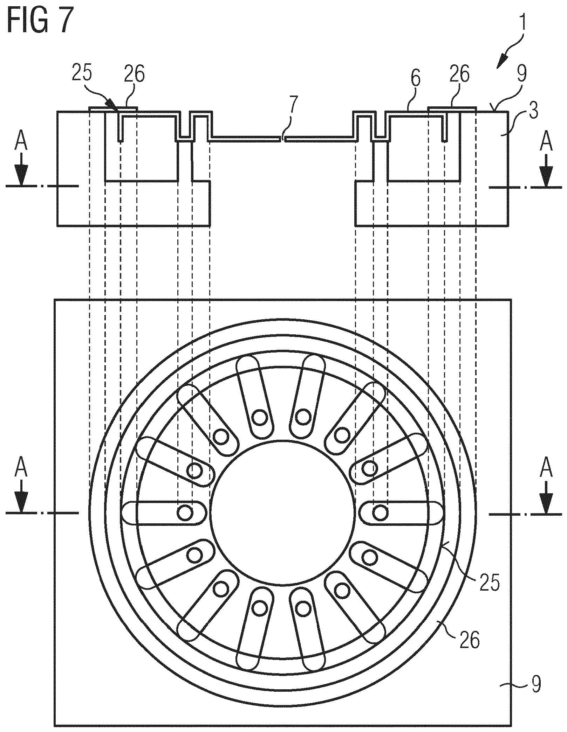

In Figure 7 a cross-section and a top-view of another embodiment of the membrane structure 1 are shown. The cross-section shows the membrane structure 1 along a cut A-A as indicated in the top-view. Measures in the cross-section, which correspond to measures in the top-view, are indicated by vertical dotted lines.

Figure 7 differs from Figure 6 in that it shows an additional elastic layer 26 connecting the thin-film structure 6 to the enclosing wall 3. This means that the elastic layer 26 is mechanically connected to a part of the top surface 9 of the enclosing wall 3 as well as to a part of the thin-film structure 6 at its outer edge 25. Thus, the elastic layer 26 spans the slit 18 between the thin-film structure 6 and the enclosing wall 3. The elastic layer 26 increases the acoustic resistance Rsl of the slit. The elastic layer 26 can be stretched so that the thin-film structure 6 can still act as a membrane, i.e. can be deflected, for example by a sound pressure wave.

The thin-film structure 6 of the embodiment of Figure 7 additionally comprises a vent hole 7 in the center of the thin-film structure 6. The vent hole 7 is provided for pressure equalization between the environment above the thin-film structure 6 and the back-volume 5. In case that the elastic layer 26 is gas-permeable, the vent hole 7 can be omitted.

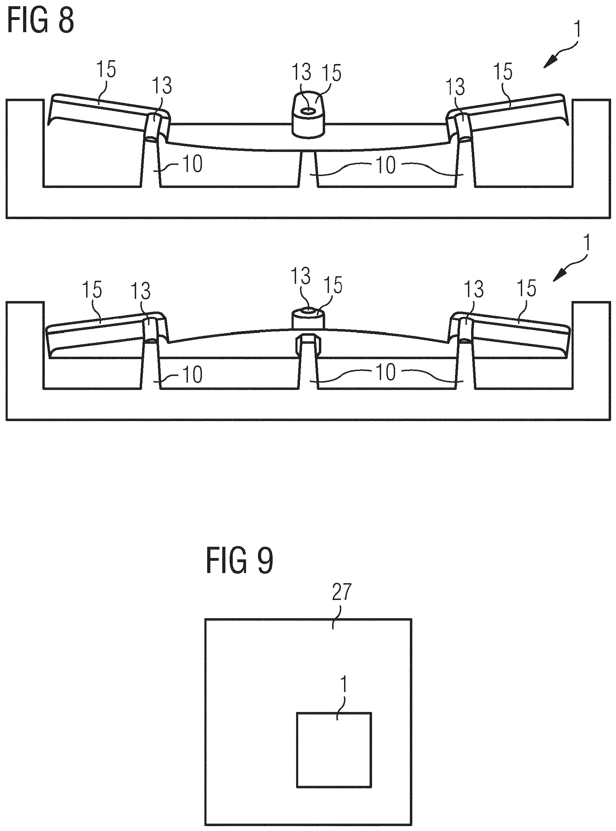

Figure 8 shows two cut-away views of another embodiment of a membrane structure 1. As in Figure 3 two states of deflection of the membrane caused by, for example, a sound pressure wave, are shown. The embodiment of Figure 8 is similar to the embodiment of Figure 6, but comprises fewer raised portions 15, protruding portions 13 and pillars 10. The membrane deflection is shown in a perspective, i.e. three-dimensional, view. It has to be noted that the pillar 10, the raised portion 15 and the protruding portion 13, which are shown in a central position of Figure 8, are located on the side of the membrane facing away from the observer.

Figure 9 shows a schematic diagram of an exemplary embodiment of a transducer device 27, comprising the membrane structure 1 as discussed above. The transducer device 27 can be, for example, an optical omnidirectional microphone or any other dynamic pressure sensing device.

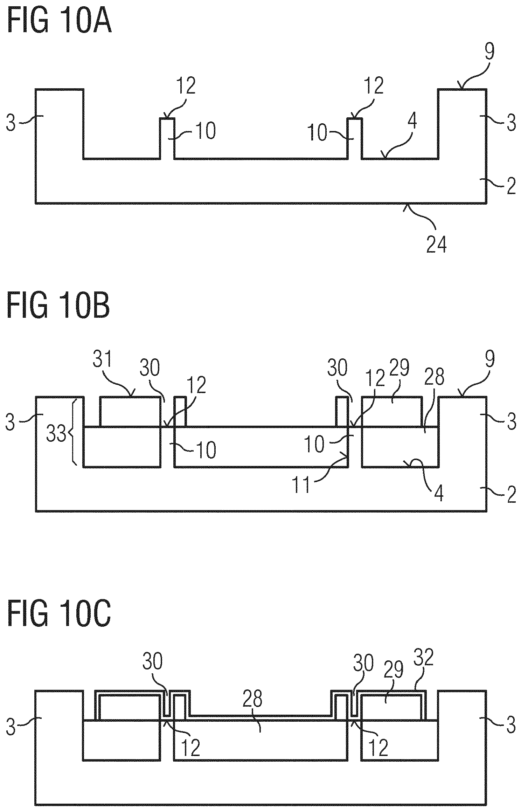

With Figures 10a to 10f an exemplary embodiment of a method of producing a membrane structure 1 is shown.

The method comprises providing a substrate 2, as shown in Figure 10a. The substrate 2 has a rear surface 24 and a main surface 4. The substrate 2 can comprise Si. On the main surface 4 etching is performed in order to form the enclosing wall 3 as well as the pillars 10. This can be done by one single etching step or by several subsequent etching steps. With respect to the main surface 4 of the substrate 2 the enclosing wall 3 can be higher than the pillars 10. This means that the top surface 9 of the enclosing wall 3 is spaced further from the main surface 4 of the substrate 2 than the support area 12 of the pillars 10. The pillars 10 are arranged within the enclosing wall 3 at a distance to the enclosing wall 3.

In a next step a first sacrificial layer 28 is deposited on the main surface 4 of the substrate 2 in the region within the enclosing wall 3 (Figure 10b). The first sacrificial layer 28 can comprise W-Ti, for example. The first sacrificial layer 28 partially fills the region within the enclosing wall 3. Thus, the first sacrificial layer 28 can cover the side surface 11s of the pillars 10. However, the first sacrificial layer 28 can leave the support area 12 of the pillars 10 uncovered.

A second sacrificial layer 29 is deposited on the first sacrificial layer 28. The second sacrificial layer 29 can comprise W-Ti as well. The second sacrificial layer 29 is formed in a region above the pillars 10, however, the lateral extent of the second sacrificial layer 29 after forming is larger than the lateral extent of the pillars 10. In lateral directions x, y the second sacrificial layer 29 is removed in regions adjacent to the enclosing wall 3. This means that there is a gap between the second sacrificial layer 29 and the enclosing wall 3. Trenches 30 are formed within the second sacrificial layer 29 above the pillars 10. The forming of the trenches 30 can be done by the same etching step as the forming of the other regions of the second sacrificial layer 29. The trenches 30 extend towards the pillars 10. The trenches 30 can have the same lateral extent as the pillars 10.

The stack of sacrificial layers 28, 29 forms the sacrificial layer region 33. With respect to the main surface 4 of the substrate 2, the sacrificial layer region 33 can have the same height as the enclosing wall 3 in places. This means that the top surface 31 of the second sacrificial layer 29 and the top surface 9 of the enclosing wall 3 lie within a plane, which runs parallel to the main plane of extension of the substrate 2. The sacrificial layers 28, 29 form regions providing a first thickness level and a second thickness level of the sacrificial layer region 33. The first thickness level is larger than the second thickness level.

In a next step a thin-film 32 is deposited in the region within the enclosing wall 3 (Figure 10c). This means that the thin-film 32 is deposited on the second sacrificial layer 29, the first sacrificial layer 28, into the trenches 30 and on the support area 12 of the pillars 10. The thin-film 32 may comprise SiN. The thin-film 32 is removed in regions adjacent to the enclosing wall 3. For example, the thin-film 32 is removed by etching. Thus, the thin-film 32 is not in mechanical contact with the enclosing wall 3.

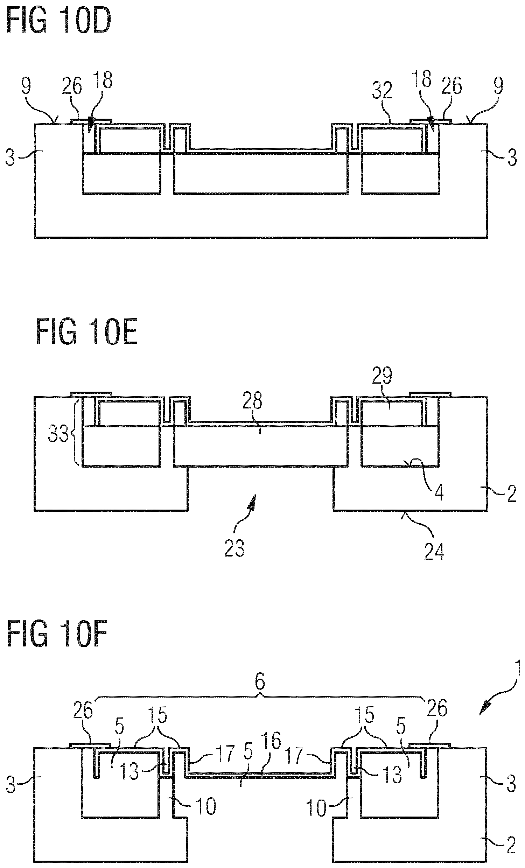

In Figure 10d the deposition of the elastic layer 26 is shown. The elastic layer 26 may comprise PDMS. The elastic layer 26 covers a part of the top surface 9 of the enclosing wall 3 and a part of the thin-film. Thus, the elastic layer 26 spans the slit 18 between the enclosing wall 3 and the thin-film.

An opening 23 is formed from the rear surface 24 to the main surface 4 of the substrate 2 towards the sacrificial layer region 33 (Figure 10e). However, the lateral extent of the opening 23 may be smaller than the lateral extent of the sacrificial layer region 33. In order to form an opening 23 the substrate 2 can be turned around and back-side treated.

In the next step the sacrificial layers 28, 29 are removed in order to release the thin-film 32 and to form the thin-film structure 6 (Figure 10f). The raised portion 15 of the thin-film structure 6 is formed by the thin-film, where it has been deposited on the first thickness level. A protruding portion 13 is formed by the part of the thin-film 32 deposited within one of the plurality of trenches 30 in the sacrificial layer region 33. A connecting portion 17 of the thin-film 32 structure 6 is formed by the part of thin-film 32 deposited between the first thickness level and the second thickness level. A lower portion 16 is formed by the part of the thin-film 32 deposited on the second thickness level. The resulting membrane structure 1 is equivalent to the embodiment of Figure 7. The membrane structure 1 is formed by the substrate 2, the enclosing wall 3, the pillars 10, the elastic layer 26, the thin-film structure 6 and the back-volume 5, which is formed by the cavity left after removing the sacrificial layer region 33. The thin-film structure 6 can form a membrane for use in a transducer device 27.

### Reference numerals

- 1: membrane structure
- 2: substrate
- 3: enclosing wall
- 4: main surface of the substrate
- 5: back-volume
- 6: thin-film structure
- 7: vent hole
- 8: side surface of enclosing wall
- 9: top surface of enclosing wall
- 10: pillar
- 11: side surface of pillar
- 12: support area of pillar
- 13: protruding portion of thin-film structure
- 14: bottom part of protruding portion
- 15: raised portion of thin-film structure
- 16: lower portion of thin-film structure
- 17: connecting portion of thin-film structure
- 18: slit between enclosing wall and thin-film structure
- 19: center part of the membrane
- 20: outer part of the membrane
- 21: mechanical phase shifter
- 22: sidewall of protruding portion
- 23: opening in substrate
- 24: rear surface of substrate
- 25: outer edge of thin-film structure
- 26: elastic layer
- 27: transducer device
- 28: first sacrificial layer
- 29: second sacrificial layer
- 30: trench in sacrificial layer region
- 31: top surface of second sacrificial layer
- 32: thin-film
- 33: sacrificial layer region
- x,y: lateral directions
- z: vertical direction
- Pa: common pressure level
- Pe: external source of sound pressure
- Zm: complex acoustic impedance of membrane
- Lm: acoustic mass of membrane
- Cm: acoustic compliance of membrane
- Rs: acoustic resistance of squeezed gas film
- Rv: acoustic resistance of vent hole
- Cv: acoustic compliance of back-volume
- Zmc: complex acoustic impedance of center part of membrane
- Lmc: acoustic mass of center part of membrane
- Cmc: acoustic compliance of center part of membrane
- Rsc: acoustic resistance of squeezed gas film under center part of membrane
- Zmo: complex acoustic impedance of outer part of membrane
- Lmo: acoustic mass of outer part of membrane
- Cmo: acoustic compliance of outer part of membrane
- Rso: acoustic resistance of squeezed gas film under outer part of membrane
- Δϕ: phase shifter
- Rp: acoustic resistance of pillars
- Rsl: acoustic resistance of slit
- Cvc: acoustic compliance of back-volume under center part of membrane
- Cvo: acoustic compliance of back-volume under outer part of membrane

## Claims

1. Membrane structure (1) comprising:
- a substrate (2) having a main surface (4) and a rear surface (24),
- a plurality of pillars (10), the pillars (10) being arranged on the main surface (4) of the substrate (2) and having a support area (12) facing away from the main surface (4) of the substrate (2), and
- a thin-film structure (6) arranged above the main surface (4) of the substrate (2) and the pillars (10), the thin-film structure (6) forming a membrane,
wherein
- the thin film structure comprises a plurality of raised portions (15) that are spaced further from the substrate (2) than at least one lower portion (16) of the thin film structure,
- the raised portions (15) each comprise at least one protruding portion (13), the protruding portions (13) being hollow and having a bottom part (14) and a sidewall (22) and the protruding portions (13) extending towards the substrate (2),
- the bottom part (14) of each protruding portion (13) is mechanically connected to the support area (12) of one of the pillars (10), respectively, and
- a back-volume (5) is formed by the volume between the main surface (4) of the substrate (2) and the thin-film structure (6),
**characterized in that**
the pillars (10) and the protruding portions (13) of the thin-film structure (6) are arranged at a predetermined distance to an outer edge of the thin-film structure (6), and **in that**
each pair of pillars (10) and protruding portions (13) forms a mechanical phase shifter during membrane deflection, wherein the mechanical phase shifter provides a phase shift of 180 degrees between an outer part (20) and a center part (19) of the membrane.

2. Membrane structure (1) according to claim 1, wherein
each raised portion (15) is completely surrounded by the at least one lower portion (16) in lateral directions (x, y), that extend parallel to a main plane of extension of the substrate (2), each raised portion (15) being connected to the at least one lower portion (16) by a connecting portion (17) .

3. Membrane structure (1) according to claim 1, wherein
each raised portion (15) extends to the outer edge of the thin-film structure (6) and is connected to the at least one lower portion (16) by a connecting portion (17).

4. Membrane structure (1) according to one of claims 1 to 3, further comprising:
at least one enclosing wall (3) arranged on the main surface (4) of the substrate (2) at a distance to the outer edge of the thin-film structure (6), the enclosing wall (3) surrounding the thin-film structure (6) in lateral directions (x, y), that extend parallel to a main plane of extension of the substrate (2).

5. Membrane structure (1) according to claim 4, further comprising:
at least one elastic layer (26) mechanically connecting the thin-film structure (6) to the enclosing wall (3).

6. Membrane structure (1) according to claim 5, wherein
the elastic layer (26) is gas-permeable.

7. Membrane structure (1) according to one of claims 1 to 6, further comprising:
an opening (23) in the substrate (2) extending from the rear surface (24) towards the thin-film structure (6) at the main surface (4) of the substrate (2).

8. Membrane structure (1) according to one of claims 1 to 7, wherein
the membrane structure (1) comprises a vent hole (7) within the thin-film structure (6).

9. Membrane structure (1) according to one of claims 1 to 8, wherein
the thin-film structure (6) has a circular or poly-angular shape in a top-view.

10. Transducer device (27) comprising the membrane structure (1) according to one of claims 1 to 9, wherein
the transducer device (27) is in particular an optical omnidirectional microphone or any other dynamic pressure sensing device.

11. Method of producing a membrane structure (1), the method comprising:
- providing a substrate (2),
- forming a plurality of pillars (10) at a main surface (4) of the substrate (2),
- forming a sacrificial layer region (33) at the main surface (4) of the substrate (2) and on the pillars (10), providing at least a first thickness level and a second thickness level of the sacrificial layer region (33), the first thickness level being larger than the second thickness level,
- forming a plurality of trenches (30) within the sacrificial layer region (33) with the first thickness level, where each trench (30) extends towards one of the pillars (10), respectively,
- depositing a thin-film (32) on the sacrificial layer region (33) and in the plurality of trenches (30), and
- forming a thin-film structure (6) from the thin-film (32) by removing the sacrificial layer region (33), the thin-film structure (6) forming a membrane, wherein
- the thin-film structure (6) comprises raised portions (15), where the raised portions (15) are formed by the part of the thin-film (32) deposited on the sacrificial layer region (33) with the first thickness level,
- each raised portion (15) comprises at least one protruding portion (13) formed by the part of the thin-film (32) deposited within the plurality of trenches (30),
- a back-volume (5) is formed by the cavity left after removing the sacrificial layer region (33), and
- the membrane structure (1) comprises the thin-film structure (6), the substrate (2) and the back-volume (5) between the thin-film structure (6) and the substrate (2),
**characterized in that**
the pillars (10) and the protruding portions (13) of the thin-film structure (6) are arranged at a predetermined distance to an outer edge of the thin-film structure (6), and **in that** each pair of pillars (10) and protruding portions (13) forms a mechanical phase shifter during membrane deflection, wherein the mechanical phase shifter provides a phase shift of 180 degrees between an outer part (20) and a center part (19) of the membrane.

12. Method according to claim 11, further comprising:
forming at least one enclosing wall (3) on the main surface (4) of the substrate (2) at a distance to the outer edge of the thin-film structure (6), the enclosing wall (3) surrounding the thin-film structure (6) in lateral directions (x, y), that extend parallel to a main plane of extension of the substrate (2).

13. Method according to claim 12, further comprising:
depositing an elastic layer (26), the elastic layer (26) mechanically connecting the thin-film structure (6) to the enclosing wall (3).

14. Method according to one of claims 11 to 13, further comprising:
- forming an opening (23) in the substrate (2), the opening (23) extending from a rear surface (24) of the substrate (2) towards the thin-film structure (6), where the rear surface (24) faces away from the main surface (4),
- removing of the sacrificial layer region (33) after forming the opening (23) in the substrate (2).

## Patentansprüche

1. Membranstruktur (1) aufweisend:
- ein Substrat (2) mit einer Hauptoberfläche (4) und einer Rückfläche (24),
- eine Vielzahl von Stützen (10), wobei die Stützen (10) auf der Hauptoberfläche (4) des Substrats (2) angeordnet sind und einen Stützbereich (12) aufweisen, der von der Hauptoberfläche (4) des Substrats (2) abgewandt ist, und
- eine Dünnschichtstruktur (6), die oberhalb der Hauptoberfläche (4) des Substrats (2) und der Stützen (10) angeordnet ist, wobei die Dünnschichtstruktur (6) eine Membran bildet, wobei
- die Dünnfilmstruktur eine Vielzahl von erhöhten Abschnitten (15) umfasst, die weiter von dem Substrat (2) beabstandet sind als mindestens ein tieferer Abschnitt (16) der Dünnfilmstruktur,
- die erhöhten Abschnitte (15) jeweils mindestens einen vorstehenden Abschnitt (13) umfassen, wobei die vorstehenden Abschnitte (13) hohl sind und einen Bodenteil (14) und eine Seitenwand (22) aufweisen und die vorstehenden Abschnitte (13) sich in Richtung des Substrats (2) erstrecken,
- der Bodenteil (14) jedes vorstehenden Abschnitts (13) mechanisch mit dem Stützbereich (12) jeweils einer der Stützen (10) verbunden ist, und
- ein Rückvolumen (5) durch das Volumen zwischen der Hauptoberfläche (4) des Substrats (2) und der Dünnschichtstruktur (6) gebildet wird,
**dadurch gekennzeichnet, dass**
- die Stützen (10) und die vorstehenden Abschnitte (13) der Dünnschichtstruktur (6) in einem vorbestimmten Abstand zu einer Außenkante der Dünnschichtstruktur (6) angeordnet sind, und
- jedes Paar von Stützen (10) und vorspringenden Abschnitten (13) einen mechanischen Phasenschieber während der Membranauslenkung bildet, wobei der mechanische Phasenschieber eine Phasenverschiebung von 180 Grad zwischen einem äußeren Teil (20) und einem mittleren Teil (19) der Membran bewirkt.

2. Membranstruktur (1) nach Anspruch 1, wobei jeder erhöhte Abschnitt (15) in seitlichen Richtungen (x, y), die parallel zu einer Haupterstreckungsebene des Substrats (2) verlaufen, vollständig von dem mindestens einen tieferen Abschnitt (16) umgeben ist, wobei jeder erhöhte Abschnitt (15) mit dem mindestens einen tieferen Abschnitt (16) durch einen Verbindungsabschnitt (17) verbunden ist.

3. Membranstruktur (1) nach Anspruch 1, wobei jeder erhöhte Abschnitt (15) sich bis zum äußeren Rand der Dünnschichtstruktur (6) erstreckt und mit dem mindestens einen tieferen Abschnitt (16) durch einen Verbindungsabschnitt (17) verbunden ist.

4. Membranstruktur (1) nach einem der Ansprüche 1 bis 3, ferner umfassend:
mindestens eine Umschließungswand (3), die auf der Hauptoberfläche (4) des Substrats (2) in einem Abstand zum äußeren Rand der Dünnschichtstruktur (6) angeordnet ist,
wobei die Umschließungswand (3) die Dünnschichtstruktur (6) in seitlichen Richtungen (x, y) umgibt, die parallel zu einer Haupterstreckungsebene des Substrats (2) verlaufen.

5. Membranstruktur (1) nach Anspruch 4, ferner umfassend:
mindestens eine elastische Schicht (26), die die Dünnschichtstruktur (6) mechanisch mit der Umschließungswand (3) verbindet.

6. Membranstruktur (1) nach Anspruch 5, wobei die elastische Schicht (26) gasdurchlässig ist.

7. Membranstruktur (1) nach einem der Ansprüche 1 bis 6, ferner umfassend:
eine Öffnung (23) im Substrat (2), die sich von der Rückseite (24) in Richtung der Dünnschichtstruktur (6) an der Hauptoberfläche (4) des Substrats (2) erstreckt.

8. Membranstruktur (1) nach einem der Ansprüche 1 bis 7, wobei die Membranstruktur (1) ein Auslassloch (7) innerhalb der Dünnschichtstruktur (6) aufweist.

9. Membranstruktur (1) nach einem der Ansprüche 1 bis 8, wobei
die Dünnschichtstruktur (6) in der Draufsicht eine kreisförmige oder vieleckige Form aufweist.

10. Wandlervorrichtung (27) mit der Membranstruktur (1) nach einem der Ansprüche 1 bis 9, wobei
die Wandlervorrichtung (27) insbesondere ein optisches ungerichtetes Mikrofon oder eine andere Vorrichtung zum Messen dynamischen Drucks ist.

11. Verfahren zur Herstellung einer Membranstruktur (1), wobei das Verfahren umfasst:
- Bereitstellen eines Substrats (2),
- Ausbilden einer Vielzahl von Stützen (10) an einer Hauptoberfläche (4) des Substrats (2),
- Ausbilden eines Opferschichtbereichs (33) an der Hauptoberfläche (4) des Substrats (2) und auf den Stützen (10), Bereitstellen mindestens eines ersten Dickenniveaus und eines zweiten Dickenniveaus des Opferschichtbereichs (33), wobei das erste Dickenniveau größer als das zweite Dickenniveau ist,
- Ausbilden einer Vielzahl von Gräben (30) innerhalb des Opferschichtbereichs (33) mit dem ersten Dickenniveau, wobei sich jeder Graben (30) jeweils zu einer der Stützen (10) hin erstreckt,
- Abscheiden eines Dünnfilms (32) auf dem Opferschichtbereich (33) und in der Vielzahl von Gräben (30), und
- Bilden einer Dünnfilmstruktur (6) aus dem Dünnfilm (32) durch Entfernen des Opferschichtbereichs (33), wobei die Dünnfilmstruktur (6) eine Membran bildet, wobei
- die Dünnfilmstruktur (6) erhöhte Abschnitte (15) aufweist, wobei die erhöhten Abschnitte (15) durch den Teil des Dünnfilms (32) gebildet werden, der auf dem Opferschichtbereich (33) mit dem ersten Dickenniveau abgeschieden ist,
- jeder erhöhte Abschnitt (15) mindestens einen vorstehenden Abschnitt (13) umfasst, der durch den Teil des Dünnfilms (32) gebildet wird, der innerhalb der Vielzahl von Gräben (30) abgeschieden ist,
- ein hinteres Volumen (5) durch den Hohlraum gebildet wird, der nach dem Entfernen des Opferschichtbereichs (33) verbleibt, und
- ein Rückvolumen (5) durch den nach dem Entfernen des Opferschichtbereichs (33) verbliebenen Hohlraum gebildet wird, und
- die Membranstruktur (1) die Dünnschichtstruktur (6), das Substrat (2) und das Rückvolumen (5) zwischen der Dünnschichtstruktur (6) und dem Substrat (2) umfasst,
**dadurch gekennzeichnet, dass**
die Stützen (10) und die vorstehenden Abschnitte (13) der Dünnfilmstruktur (6) in einem vorbestimmten Abstand zu einem äußeren Rand der Dünnfilmstruktur (6) angeordnet sind, und dass jedes Paar von Stützen (10) und vorstehenden Abschnitten (13) einen mechanischen Phasenschieber während der Membranauslenkung bildet, wobei der mechanische Phasenschieber eine Phasenverschiebung von 180 Grad zwischen einem äußeren Teil (20) und einem mittleren Teil (19) der Membran bereitstellt.

12. Verfahren nach Anspruch 11, ferner umfassend:
Ausbilden mindestens einer Umschließungswand (3) auf der Hauptoberfläche (4) des Substrats (2) in einem Abstand zum äußeren Rand der Dünnschichtstruktur (6), wobei die Umschließungswand (3) die Dünnschichtstruktur (6) in seitlichen Richtungen (x, y) umgibt, die sich parallel zu einer Haupterstreckungsebene des Substrats (2) erstrecken.

13. Verfahren nach Anspruch 12, ferner umfassend:
Aufbringen einer elastischen Schicht (26), wobei die elastische Schicht (26) die Dünnschichtstruktur (6) mechanisch mit der Umschließungswand (3) verbindet.

14. Verfahren nach einem der Ansprüche 11 bis 13, ferner umfassend:
- Ausbilden einer Öffnung (23) in dem Substrat (2), wobei sich die Öffnung (23) von einer Rückseite (24) des Substrats (2) zu der Dünnschichtstruktur (6) erstreckt, wobei die Rückseite (24) von der Hauptoberfläche (4) abgewandt ist,
- Entfernen des Opferschichtbereichs (33) nach dem Ausbilden der Öffnung (23) in dem Substrat (2).

## Revendications

1. Structure de membrane (1), comprenant:
- un substrat (2) ayant une surface principale (4) et une surface arrière (24),
- une pluralité de piliers (10), les piliers (10) étant disposés sur la surface principale (4) du substrat (2) et ayant une zone de support (12) orientée à l'opposé de la surface principale (4) du substrat (2), et
- une structure à couche mince (6) disposée au-dessus de la surface principale (4) du substrat (2) et des piliers (10), la structure à couche mince (6) formant une membrane, dans laquelle
- la structure à couche mince comprend une pluralité de parties surélevées (15) qui sont plus éloignées du substrat (2) qu'au moins une partie inférieure (16) de la structure à couche mince,
- les parties surélevées (15) comprennent chacune au moins une partie saillante (13), les parties saillantes (13) étant creuses et ayant une partie basse (14) et une paroi latérale (22) et les parties saillantes (13) s'étendant vers le substrat (2),
- la partie basse (14) de chaque partie saillante (13) est reliée mécaniquement à la zone de support (12) de l'un des piliers (10), respectivement, et
- un volume arrière (5) est formé par le volume entre la surface principale (4) du substrat (2) et la structure à couche mince (6),
**caractérisé en ce que**
les piliers (10) et les parties saillantes (13) de la structure à couche mince (6) sont disposés à une distance prédéterminée d'un bord extérieur de la structure à couche mince (6), et **en ce que**
chaque paire de piliers (10) et de parties saillantes (13) forme un déphaseur mécanique pendant la déviation de la membrane,
dans laquelle le déphaseur mécanique assure un déphasage de 180 degrés entre une partie extérieure (20) et une partie centrale (19) de la membrane.

2. Structure de membrane (1) selon la revendication 1, dans laquelle chaque partie surélevée (15) est complètement entourée par au moins une partie inférieure (16) dans des directions latérales (x,y), qui s'étendent parallèlement à un plan principal d'extension du substrat (2), chaque partie surélevée (15) étant reliée à l'au moins une partie inférieure (16) par une partie de connexion (17).

3. Structure de membrane (1) selon la revendication 1, dans laquelle chaque partie surélevée (15) s'étend au bord extérieur de la structure à couche mince (6) et est reliée à l'au moins une partie inférieure (16) par une partie de connexion (17).

4. Structure de membrane (1) selon l'une des revendications 1 à 3, comprenant en outre:
au moins une paroi d'enceinte (3) disposée sur la surface principale (4) du substrat (2) à une distance du bord extérieur de la structure à couche mince (6), la paroi d'enceinte (3) entourant la structure à couche mince (6) dans des directions latérales (x, y), qui s'étendent parallèlement à un plan principal d'extension du substrat (2).

5. Structure de membrane (1) selon la revendication 4, comprenant en outre:
au moins une couche élastique (26) reliant mécaniquement la structure à couche mince (6) à la paroi d'enceinte (3).

6. Structure de membrane (1) selon la revendication 5, dans laquelle la couche élastique (26) est perméable aux gaz.

7. Structure de membrane (1) selon l'une des revendications 1 à 6, comprenant en outre:
une ouverture (23) dans le substrat (2), s'étendant de la surface arrière (24) vers la structure à couche mince (6) sur la surface principale (4) du substrat (2).

8. Structure de membrane (1) selon l'une des revendications 1 à 7, dans laquelle
la structure de membrane (1) comprend un trou de ventilation (7) dans la structure à couche mince (6).

9. Structure de membrane (1) selon l'une des revendications 1 à 8, dans laquelle
la structure à couche mince (6) a une forme circulaire ou poly-angulaire en vue de dessus.

10. Dispositif transducteur (27) comprenant la structure de membrane (1) selon l'une des revendications 1 à 9, dans laquelle
le dispositif transducteur (27) est en particulier un microphone optique omnidirectionnel ou tout autre dispositif de détection de pression dynamique.

11. Méthode de production d'une structure de membrane (1), comprenant:
- fournir un substrat (2),
- former une pluralité de piliers (10) sur la surface principale (4) du substrat (2),
- former une région de couche sacrificielle (33) sur la surface principale (4) du substrat (2) et sur les piliers (10), fournir au moins un premier niveau d'épaisseur et un deuxième niveau d'épaisseur de la région de couche sacrificielle (33), le premier niveau d'épaisseur étant plus grand que le deuxième niveau d'épaisseur,
- former une pluralité de tranchées (30) dans la région de couche sacrificielle (33) avec le premier niveau d'épaisseur, où chaque tranchée (30) s'étend vers l'un des piliers (10), respectivement,
- déposer une couche mince (32) sur la région de couche sacrificielle (33) et dans la pluralité de tranchées (30), et
- former une structure à couche mince (6) à partir de la couche mince (32) en enlevant la région de couche sacrificielle (33), la structure à couche mince (6) formant une membrane, dans laquelle
- la structure à couche mince (6) comprend des parties surélevées (15), les parties surélevées (15) étant formées par la partie de la couche mince (32) déposée sur la région de couche sacrificielle (33) avec le premier niveau d'épaisseur,
- chaque partie surélevée (15) comprend au moins une partie saillante (13) formée par la partie de la couche mince (32) déposée dans la pluralité de tranchées (30),
- un volume arrière (5) est formé par la cavité laissée après l'élimination de la région de couche sacrificielle (33), et
- la structure de membrane (1) comprend la structure à couche mince (6), le substrat (2) et le volume arrière (5) entre la structure à couche mince (6) et le substrat (2),
**caractérisé en ce que**
les piliers (10) et les parties saillantes (13) de la structure à couche mince (6) sont disposés à une distance prédéterminée d'un bord extérieur de la structure à couche mince (6), et **en ce que** chaque paire de piliers (10) et de parties saillantes (13) forme un déphaseur mécanique pendant la déviation de la membrane,
dans laquelle le déphaseur mécanique assure un déphasage de 180 degrés entre une partie extérieure (20) et une partie centrale (19) de la membrane.

12. Méthode selon la revendication 11, comprenant en outre:
former au moins une paroi d'enceinte (3) sur la surface principale (4) du substrat (2) à une distance du bord extérieur de la structure à couche mince (6), la paroi d'enceinte (3) entourant la structure à couche mince (6) dans des directions latérales (x, y), qui s'étendent parallèlement à un plan principal d'extension du substrat (2).

13. Méthode selon la revendication 12, comprenant en outre:
déposer une couche élastique (26), la couche élastique (26) reliant mécaniquement la structure à couche mince (6) à la paroi d'enceinte (3).

14. Méthode selon l'une des revendications 11 à 13, comprenant en outre :
- former une ouverture (23) dans le substrat (2), l'ouverture (23) s'étendant d'une surface arrière (24) du substrat (2) vers la structure à couche mince (6), la surface arrière (24) étant orientée à l'opposé de la surface principale (4),
- enlever la région de couche sacrificielle (33) après former l'ouverture (23) dans le substrat (2).
